Europäisches Patentamt

European Patent Office

Office européen des brevets

(11) Publication number: 0 332 218 A2

## EUROPEAN PATENT APPLICATION

(21) Application number: 89104323.4

(22) Date of filing: 10.03.89

(51) Int. Cl.4: H01L 39/24 , C04B 35/50 , C23C 14/58

(30) Priority: 10.03.88 JP 56809/88

(43) Date of publication of application:
13.09.89 Bulletin 89/37

(84) Designated Contracting States:
DE FR GB

(71) Applicant: Mitsubishi Metal Corporation
No. 5-2, Ohtemachi, 1-chome Chiyoda-ku
Tokyo 100(JP)

(72) Inventor: Takeshita, Takuo c/o Mitsubishi
Metal Corp.
Chuo Kenkyujo 297, Kitabukurocho 1-chome
Omiya-shi Saitama 330(JP)
Inventor: Sugihara, Tadashi c/o Mitsubishi
Metal Corp.
Chuo Kenkyujo 297, Kitabukurocho 1-chome
Omiya-shi Saitama 330(JP)

(74) Representative: Glawe, Delfs, Moll & Partner
Patentanwälte
Postfach 26 01 62
D-8000 München 26(DE)

(54) Process of forming superconducting film.

(57) A superconductive film (10) deposited on a substrate (8 or 9) is usually covered with an undesirable surface film, and the surface film is removed by using an ion milling according to the present invention, so that a fresh surface is exposed without any oxygen attack, and a smooth topography is created.

## Figure

EVACUATION

## PROCESS OF FORMING SUPERCONDUCTING FILM

### FIELD OF THE INVENTION

This invention relates to a superconductor and, more particularly, to a process of forming a superconductive film on a substrate.

### BACKGROUND OF THE INVENTION

A wide variety of practical application has been proposed for a high temperature superconductor, and attempts have been, by way of example, made to develop a film formation process used in fabrication of semiconductor devices.

One of the film formation processes is related to sputtering techniques, and another process is associated with physical vapor deposition techniques. If a sputtering technique is applied to the film formation process, a target is formed of a superconductive oxide containing a rare earth metal such as yttrium, an alkaline earth metal, copper and oxygen. The target is sputtered to deposit a thin film of the superconductive oxide on a substrate. However, the thin film is covered with an undesirable surface film, and the superconductivity tends to be suppressed due to the surface film. For this reason, the sputtering stage is usually followed by a heat treatment which aims at refining the surface film, and the heat treatment is carried out in a high temperature oxidation ambient ranging between about 700 degrees and about 950 degrees in centigrade for an hour.

However, a problem is encountered in the prior art refining technique in that the thin film are liable to have a rough surface due to an oxygen attack during the heat treatment. This results in that the superconductive wiring strip loses the smooth topography which in turn is causative of deterioration in production yield. The prior art refining technique further has a problem in production of cracks. This is because of the fact that the substrate is usually different in thermal expansion coefficient from the superconductive strip.

### SUMMARY OF THE INVENTION

It is therefore an important object of the present invention to provide a process of forming a superconducting film which creates a smooth topography.

It is another important object of the present invention to provide a removing technique for the undesirable surface film without any heat treatment.

To accomplish these objects, the present invention proposes to apply an ion milling to the formation process of the superconductive film.

In accordance with the present invention, there is provided a process for forming a superconductive film, comprising the steps of: a) preparing a lower film structure and a bulk of a superconductive oxide; b) transferring a part of the bulk so as to deposit an upper film of the superconductive oxide on the lower film structure, an undesirable surface film being produced and covering the upper film; and c) removing the undesirable surface film by using an ion milling.

### BRIEF DESCRIPTION OF THE DRAWINGS

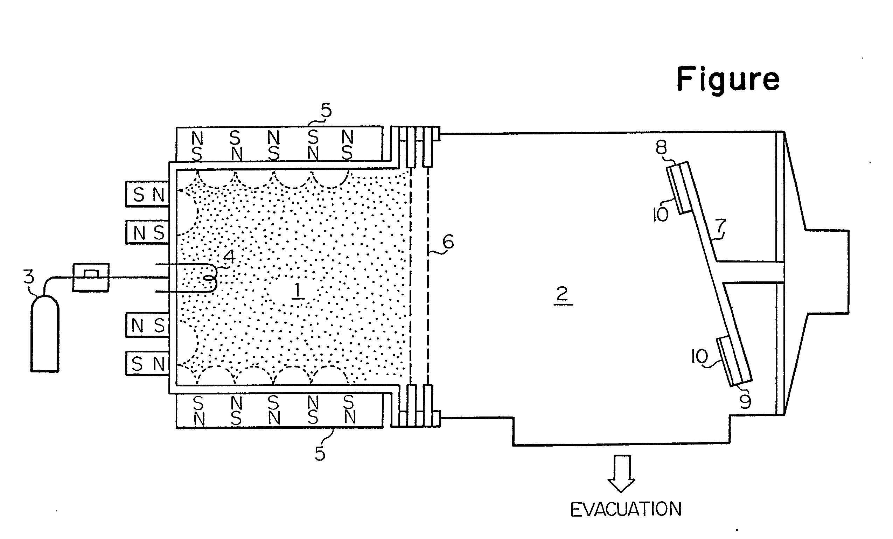

The features and advantages of a process according to the present invention will be more clearly understood from the following description taken in conjunction with the accompanying drawing in which the figure is a schematic view showing the arrangement of an ion milling system used in the process according to the present invention.

## DESCRIPTION OF THE PREFERRED EMBODIMENTS

Referring to the figure, an ion milling system is provided with a plasma chamber 1 as well as a sputtering chamber 2.

The ion milling system is used in a process of forming a superconducting film embodying the present invention. The ion milling system is associated with a gas source 3 which supplies the plasma chamber 1 with argon gas, however, another gas such as, for example, xenon gas, helium gas, neon gas, krypton gas or oxygen gas is available. The plasma chamber 1 is accompanied with a cathode 4 and a magnet unit 5, and electrons discharged from the cathode 4 are guided by the magnetic field created by the magnet unit 5, so that the argon gas supplied to the plasma chamber 1 is ionized to produce a plasma. Between the plasma chamber 1 and the sputtering chamber 2 is provided a guide electrode 6 which guides the plasma to a holder 7 in the sputtering chamber 2. On the holder 7, substrates 8 and 9 respectively formed with superconductive films 10 are mounted and, for this reason, subjected to a bombardment of the plasma. With the bombardment of the plasma, the surface portion of each superconductive film 10 is etched away to expose a fresh surface thereof.

The process sequence starts with preparation of targets of various superconductive oxides indicated in Table 1. Each of the targets is installed in a sputtering chamber defined in a sputtering system and faced to a substrate by a distance of about 90 millimeters. The substrate is formed of a single crystal magnesium oxide (MgO) and has a square surface of about 10 millimeters x about 10 millimeters. The substrate is heated up to about 650 degrees in centigrade, and, then, a gaseous mixture is supplied to a plasma chamber of the sputtering system. In this instance, the gaseous mixture contains argon and oxygen mixed in a proportion of 3 : 1. A low pressure ambient of about $5 \times 10^{-8}$ torr is created in the plasma chamber for producing a plasma, and the plasma bombards the target, thereby allowing the superconductive oxide to be deposited to a thickness of about 2 microns on the substrate. The sputtering is thus carried out at about 200 watts for about 10 hours and repeated with the targets of the various superconductive oxides. As a results, films of the various superconductive oxides are produced on the substrates, respectively, and a plurality of films of each superconductive oxide are divided into two groups for evaluation described hereinafter.

After the deposition stage, the superconductive films of the first groups are mounted on the holder 7 and subjected to the ion milling in an argon ambient for about 3 hours. The ion milling is carried out at about 600 volts for the ionization and at about 780 mA/cm² as the beam current density. On the other hand, the superconductive films of the second groups are subjected to a heat treatment in an oxidation ambient at about 910 degrees in centigrade for about an hour.

All of the superconductive films are observed to see whether or not cracks are produced therein, and the surface roughness, the critical current density and the critical temperature are measured for each superconductive film. The results are indicated in Table 2. (blank)

Table 1

| Specimen | Composition of Target (weight %) | | | | Removing technique |
|---|---|---|---|---|---|
| | R.M. | A.M. | Cu | Oxide | |
| 1 | Ho: 20.4 Sc: 0.6 | Ba: 37.8 | 26.2 | Residual | Ion milling |
| 2 | Same as specimen 1 | | | | Heat treatment |
| 3 | Y: 13.4 | Ba: 41.4 | 28.7 | Residual | Ion milling |
| 4 | Same as specimen 3 | | | | Heat treatment |
| 5 | Sm: 20.9 | Ba: 36.3 Sr: 1.2 | 26.5 | Residual | Heat treatment |
| 6 | Same as specimen 5 | | | | Heat treatment |
| 7 | Eu: 20.9 | Ba: 37.8 | 26.2 | Residual | Ion milling |
| 8 | Same as specimen 7 | | | | Heat treatment |
| 9 | Dy: 13.2 Yb: 9.3 | Ba: 37.1 | 25.7 | Residual | Ion milling |
| 10 | Same as specimen 9 | | | | |

In Table 1, rare earth metal and alkaline earth metal are respectively abbreviated as "R.M." and "A.M.". (blank)

Table 2

| Specimen | Surface roughness (micron) | Cracks | Jc (A/cm$^2$) | Tc (degree in Kelvin) |
|---|---|---|---|---|
| 1 | not greater than 0.01 | none | $3 \times 10^5$ | 70 |
| 2 | 0.2 | produced | $1 \times 10^5$ | 71 |
| 3 | not greater than 0.01 | none | $3.3 \times 10^5$ | 68 |
| 4 | 0.1 | produced | $5 \times 10^4$ | 68 |
| 5 | not greater than 0.01 | none | $2.5 \times 10^5$ | 72 |
| 6 | 0.2 | produced | $1.2 \times 10^5$ | 71 |
| 7 | not greater than 0.01 | none | $3 \times 10^5$ | 66 |
| 8 | 0.2 | produced | $8 \times 10^4$ | 65 |
| 9 | not greater than 0.01 | none | $2.8 \times 10^5$ | 67 |
| 10 | 0.1 | produced | $7 \times 10^4$ | 67 |

Jc and Tc stand for the critical current density and the critical temperature, respectively.

As will be understood from Tables 1 and 2, the superconductive films formed by the process according to the present invention are advantageous over the superconductive films produced in the prior-art process in the surface roughness and, accordingly, the smooth topography. Moreover, no crack takes place in the superconductive films produced by the process according to the present invention, so that the production yield are improved.

Although particular embodiments of the present invention have been shown and described, it will be

4

obvious to those skilled in the art that various changes and modifications may be made without departing from the spirit and scope of the present invention. For example, the deposition stage may be carried out by using a physical vapor deposition. Moreover, the superconductive film may be patterned to form an electrical wiring strip. .

## Claims

1. A process for forming a superconductive film, comprising the steps of a) preparing a lower film structure and a bulk of a superconductive oxide and b) transferring a part of said bulk so as to deposit an upper film of the superconductive oxide on said lower film structure, an undesirable surface film being produced and covering said upper film, characterized by the step of removing said undesirable surface film by using an ion milling.

Figure

EVACUATION